(19) Europäisches Patentamt
European Patent Office
Office européen des brevets

(11) EP 0 789 866 B1

(12) EUROPÄISCHE PATENTSCHRIFT

(45) Veröffentlichungstag und Bekanntmachung des Hinweises auf die Patenterteilung:
13.01.1999 Patentblatt 1999/02

(51) Int Cl.6: **G05F 3/30**, G01R 35/00

(86) Internationale Anmeldenummer:
PCT/DE95/01409

(21) Anmeldenummer: 95934589.3

(22) Anmeldetag: 13.10.1995

(87) Internationale Veröffentlichungsnummer:
WO 96/14613 (17.05.1996 Gazette 1996/22)

(54) **SPANNUNGSREFERENZ MIT PRÜFUNG UND EIGENKALIBRIERUNG**

VOLTAGE REFERENCE WITH TESTING AND SELF-CALIBRATION

REFERENCE DE TENSION AVEC ESSAI ET AUTO-ETALONNAGE

(84) Benannte Vertragsstaaten:
DE FR GB IT

(30) Priorität: 05.11.1994 DE 4439707

(43) Veröffentlichungstag der Anmeldung:
20.08.1997 Patentblatt 1997/34

(73) Patentinhaber: ROBERT BOSCH GMBH
70442 Stuttgart (DE)

(72) Erfinder: TENTEN, Wilfried
D-72501 Gammertingen (DE)

(56) Entgegenhaltungen:
EP-A- 0 499 657          DE-A- 2 739 529
US-A- 4 590 418          US-A- 5 053 640

• IEEE JOURNAL OF SOLID-STATE CIRCUITS, Bd. 26, Nr. 1, Januar 1991 NEW YORK US, Seiten 41-50, NICOLLINI ET AL. 'A CMOS BANDGAP REFERENCE...'

**Beschreibung**

Stand der Technik

Die Erfindung geht aus von einer Spannungsreferenzschaltung bzw. einem Verfahren nach der Gattung der unabhängigen Ansprüche, wie sie beispielsweise als Bandabstands-Referenz (Bandgap) bekannt ist. Derartige Spannungsreferenzen sind in großer Vielfalt als integrierte Schaltung handelsüblich. Sie werden während des Herstellungsprozesses bezüglich ihres Temperaturgradienten mit einer bestimmten Toleranzbreite derart kalibriert, daß der physikalisch bedingte Temperaturkoeffizient kompensiert ist. Durch Alterungseinflüsse kann jedoch diese Kalibrierung vernichtet werden, so daß unter Umständen die Spannungsreferenz für die nachfolgenden Schaltungen eine unzulässige Spannung liefert. Dadurch kann ein erhöhtes Funktionsrisiko für die nachgeschalteten Schaltungen entstehen.

Die Druckschrift DE 27 39 529 beschreibt eine Schaltungsanordnung zum Selbsteichen eines Voltmeters. Die Schaltungsanordnung weist Schalter auf, über die wahlweise eine gegebene, von einer nicht näher beschriebenen Referenzspannungsquelle gelieferte Referenzspannung, das Massepotential oder eine zu messende Eingangsspannung an eine ausgewählte Schaltungselement-Konfiguration angelegt werden kann.

Die Druckschrift IEEE Journal of Solid-State Circuits 26(1991) January, No. 1, New York, US, Seiten 41 bis 50 beschreibt eine Spannungsreferenz, die einen Schaltkreis zur Kompensation einer Temperaturabhängigkeit der Ausgangsspannung aufweist.

Vorteile der Erfindung

Die erfindungsgemäße Spannungsreferenz bzw. das Verfahren mit den kennzeichnenden Merkmalen der unabhängigen Ansprüche hat demgegenüber den Vorteil, daß eine Überprüfung der Spannungsreferenz auch während der Lebensdauer wiederholt und zu beliebigen Zeitpunkten durchgeführt werden kann. Ein weiterer Vorteil besteht darin, daß bei der wiederholten Prüfung auch eine erneute Eigenkalibrierung durchgeführt werden kann, so daß die Ausgangsspannung der Spannungsreferenz sehr zuverlässig ist. Defekte oder Alterungseinflüsse können somit erkannt bzw. eliminiert werden.

Besonders vorteilhaft ist, daß mittels einfacher Schalter, die vorzugsweise als MOS-Schalter ausgebildet sind, die Selbstprüfung und/oder Eigenkalibrierung durchgeführt werden kann. Im Normalbetrieb sind diese Schalter wirkungslos, so daß sie die Spannungsreferenz nicht beeinflussen.

Bei Verwendung eines Operationsverstärkers kann der Temperaturkoeffizient auf einfache Weise mit Hilfe eines Spannungsteilers eingestellt werden. Zum Abgleich des Temperaturkoeffizienten wird dabei wenigstens ein Widerstand veränderbar ausgeführt. Dieses kann dadurch erfolgen, daß beispielsweise der Rückkopplungswiderstand durch Parallelschalten weiterer Widerstände verändert wird. Diese Parallelschaltung läßt sich durch programmierbar ausgelegte Widerstands- bzw. Stromnetzwerke darstellen. Da die während der Kalibrierung verwendeten MOS-Schalter jedoch nicht ideal sind, sondern einen endlichen ON-Widerstand haben, kann dieser auf einfache Weise durch die Parallelschaltung zweier MOS-Schalter ermittelt werden. Der Schaltereinfluß läßt sich dann vorteilhaft rechnerisch ermitteln.

Durch die in den abhängigen Ansprüchen aufgeführten Maßnahmen sind vorteilhafte Weiterbildungen und Verbesserungen der Spannungsreferenz bzw. des Verfahrens zur Kalibrierung nach den nebengeiordneten Ansprüchen 1 und 9 gegeben.

Für vorgegebene Zeiten, beispielsweise beim Anlegen der Betriebsspannung bzw. bei Anforderung beispielsweise durch eine Steuerung, werden die Schalter mit einem vorgegebenen Steuerprogramm derart gesteuert, daß der Selbsttest und/oder die Eigenkalibrierung durchführbar ist.

Für dieses Abgleichverfahren eignet sich besonders eine auf Operationsverstärker beruhende Schaltungstechnik einer Bandgap-Referenzquelle. Diese Schaltung ist auch für Anwendungen mit geringer Batteriespannung geeignet.

Ein Ausführungsbeispiel der Erfindung ist in der Zeichnung dargestellt und in der nachfolgenden Beschreibung näher erläutert. Es zeigen Figur 1 eine Bandgap-Spannungsreferenz, Figur 2 zeigt einen Operationsverstärker mit Gegenkopplung, Figur 3 zeigt ein zweites Schaltbild des Operationsverstärkers, Figur 4 zeigt ein drittes Schaltbild des Operationsverstärkers, Figur 5 zeigt das Gesamtschaltbild eines Ausführungsbeispiels, Figur 6 zeigt ein Flußdiagramm und die Figuren 7 und 8 zeigen zwei weitere Flußdiagramme.

Beschreibung des Ausführungsbeispiels

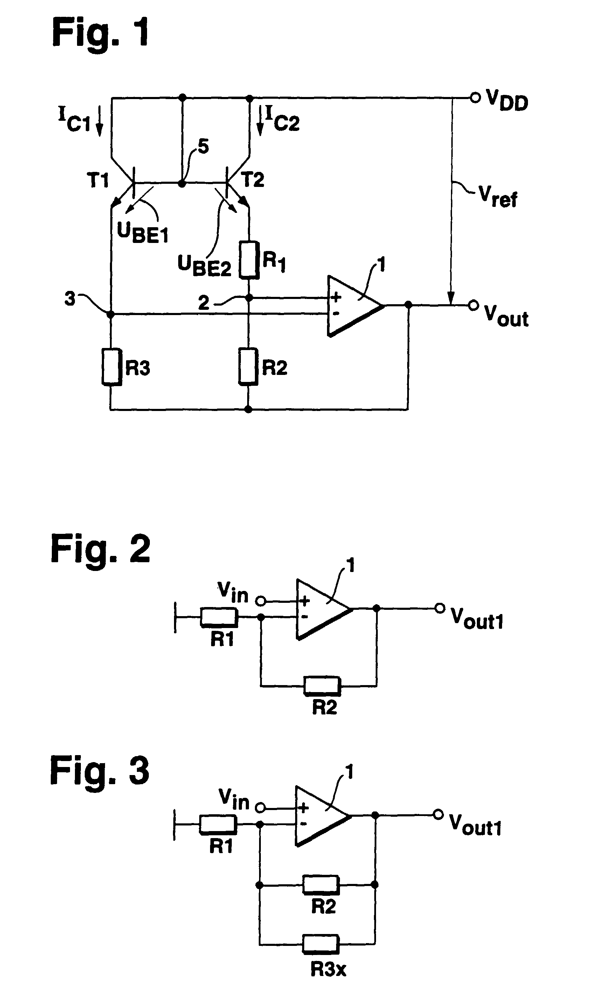

Figur 1 zeigt eine Spannungsreferenz, die als Bandgap-Referenz ausgebildet ist. Bandgap-Spannungsreferenzquellen sind per se bekannt. Sie basieren darauf, daß eine Durchlaßspannung einer Diode oder die Basis-Emitter-Spannung eines Bipolartransistors als Spannungsreferenz verwendet wird. Diese Referenzspannung hat jedoch den Nachteil, daß sie beispielsweise bei Silicium-Bipolartransistoren einen Temperaturkoeffizienten von ca. -2 mV/K aufweist. Daher werden die Schaltungen derart ausgebildet, daß der negative Temperaturkoeffizient durch einen entsprechend großen positiven Temperaturkoeffizienten kompensiert wird. Wie der Figur 1 entnehmbar ist, wird ein Operationsverstärker 1 von zwei als Stromspiegel geschalteten Bipolar-Transistoren T1, T2, z. B des Leitfähigkeitstyps npn, gespeist. Im Emitter-Strompfad des Transistors T2 ist ein Spannungsteiler mit den Widerständen R1, R2 geschaltet, wobei der Mittenabgriff des Spannungsteilers am Knoten 2 auf den nichtinvertierenden Eingang des Operationsverstärkers 1 geführt ist. Im Emitter-Strompfad des Transistors T1 ist ein Widerstand R3 geschaltet, der am Knoten 3 auf den invertierenden Eingang (-) des Operationsverstärkers 1 geführt ist. Die Schaltung wird von einer Versorgungsspannung $V_{DD}$ und $V_{SS}$ gespeist. Die Referenzspannung $V_{Ref}$ kann zwischen den Klemmen VDD und dem Ausgang $V_{OUT}$ des Operationsverstärkers 1 abgegriffen werden. Bei Verwendung von pnp-Transistoren würde der Bandgap-Ausgang stabil gegenüber $V_{SS}$ sein. Der Ausgang V ist zusammen mit den zweiten Anschlüssen der Widerstände R3 und R2 verbunden. Die Schaltung wird vorzugsweise als integrierte Schaltung ausgebildet, wobei die Transistoren T1, T2 in Bipolartechnik ausgeführt sind, während die übrigen Schaltungsteile beispielsweise in CMOS-Technik integriert sind.

Gemäß der Figur 1 werden die Transistoren T1, T2 mit verschiedenen Kollektorströmen $I_{C1}$ bzw. $I_{C2}$ betrieben. Dadurch ergibt sich in Abhängigkeit von der Temperatur aus den beiden Basis-Emitter-Spannungen der Transistoren T1, T2 ein zur Temperaturspannung $U_T = 87\ \mu V/K$ gegenläufiger Temperaturkoeffizient. Mit Hilfe eines bestimmten Verstärkungsfaktors kann die Temperaturspannung $U_T$ derart verstärkt werden, daß die Schaltung einen definierten Temperaturkoeffizienten annimmt. Dieser Wert kann negativ, positiv oder auch Null sein. Beim Wert = 0 ist die Bandgap-Bedingung erfüllt, d. h. die Referenzquelle ist temperaturunabhängig.

Die folgenden Gleichungen bescheiben diese Bedingung für die beiden Dioden. Die Basis-Emitter-Spannung $V_{BE1}$, $V_{BE2}$ der beiden Transistoren T1, T2 ist aufgrund der physikalischen Gegebenheiten

$$V_{BE1} = U_T * \ln \frac{I_{C1}}{AT\chi} \qquad \text{(Gleichung 1)}$$

$$V_{BE2} = U_T * \ln \frac{I_{C2}}{AT\chi} \qquad \text{(Gleichung 2),}$$

wobei A die Emitterfläche und $\chi$ der Temperaturkoeffizient der beiden Transistoren T1, T2 ist.

Der Spannungsabfall über dem Widerstand R1 ergibt sich aufgrund der Schaltungstechnik zu:

$$V_{R1} = \Delta V_{BE} = V_{BE2} - U_{BE1} = U_T * \ln \frac{I_{C1}}{I_{C2}} = U_T * \ln \frac{R2}{R3} \qquad \text{(Gleichung 3).}$$

Unter Berücksichtigung dieser Beziehung erfolgt dann die Schreibweise der Bandgap-Bedingung zu:

$$V_{Ref} = V_{BE2} + U_T * (1 + \frac{R2}{R1} * \ln \frac{R2}{R3}) \qquad \text{(Gleichung 4).}$$

Dabei stellt der Term bei $U_T$ den bereits oben erwähnten Verstärkungsfaktor dar. Betrachtet man diese Gleichung etwas näher, so wird offensichtlich, daß der Faktorterm nur aus Widerstandsverhältnissen besteht und daß darüber hinaus in beiden inneren Termen der Widerstand R2 jeweils im Zähler steht. Nutzt man unter Berücksichtigung beispielsweise der CMOS-Schaltungstechnik diesen Umstand aus, so läßt sich durch Einfügen einiger Schalter in nicht stromführende Pfade der innerhalb dieser Baugruppe verwendete Operationsverstärker 1 jeweils so beschalten, daß er einmal mit dem Verhältnis R2/R1 als nicht invertierender Verstärker und das andere Mal mit der Parallelschaltung aus R2 und R3 sowie - wiederum bezogen auf R1 - als nicht invertierender Operationsverstärker wirkt. Figur 2 zeigt, daß die Verstärkung vom Verhältnis R2/R1 des Operationsverstärkers 1 abhängt. In Figur 3 ist dem Widerstand R2 im Rückkopplungszweig ein weiterer Widerstand R3x parallelgeschaltet. Der Verstärkungsfaktor für die Temperaturspannung $U_T$ wird somit aus der Parallelschaltung der Widerstände R2, R3x im Verhältnis zum Widerstand R1 gebildet, d. h. die Ausgangsspannung des Verstärkers 1 ist entsprechend der nachfolgenden Gleichungen somit:

$$V_{OUT1} = V_{IN} * (1 + \frac{R2}{R1}) \qquad \text{(Gleichung 5)}$$

und

$$V_{OUT2} = V_{IN} * (1 + \frac{(R2 * R3x)/(R2+R3x)}{R1}) \qquad \text{(Gleichung 6)}.$$

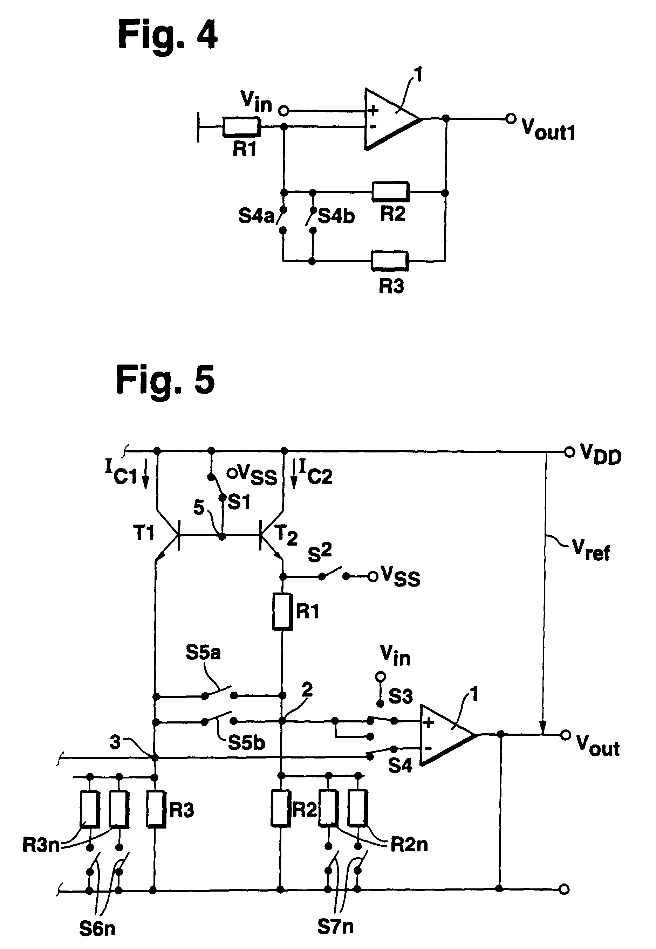

Der Widerstand R3x enthält dabei einen Widerstand R3 sowie die Parallelschaltung der beiden Widerstände der Schalter S5a und S5b, die mit dem Widerstand R3 in Reihe geschaltet sind, gemäß der Figur 4. Da diese Schalter beispielsweise in CMOS-Technik als Transistorschalter realisiert sind, ist deren Widerstand nicht zu vernachlässigen. Die beiden Schalter S5a und S5b entsprechen zwei gleichen Transistoren. Die Schalter werden nacheinander geschlossen. Für jede der beiden Stellungen der Schalter S5a, S5b wird der Ausgangsspannungswert des Operationsverstärkers 1 gemessen. Zur Bestimmung der Widerstandsgröße kommt es dabei nicht auf den absoluten Wert an, sondern auf die Relation beider Meßergebnisse. Für die Bestimmung des Widerstandes der beiden Schalter S5a, S5b gemäß der Figur 4 gelten die Gleichungen

$$F1 = \frac{R2 * (R3 + S4a)}{R2 + R3 + S4a} \qquad \text{(Gleichung 7)}$$

$$F2 = \frac{R2 * (R3 + 0{,}5\ S4a)}{R2 + R3 + 0{,}5\ S4a} \qquad \text{(Gleichung 8)}.$$

Aus diesen beiden Gleichungen kann der Widerstand S4a bestimmt werden, da die Faktoren F1 bzw. F2 unter Zuhilfenahme der Gleichung 5 gemessen wird. F1 und F2 stellen eine vereinfachte Schreibweise der Gleichung 6 dar. Es gilt:

$$V_{OUT2} = V_{IN} (1 + F1)$$

$$V_{OUT2} = V_{IN} (1 + F2)$$

Durch Einsetzen in Gleichung 6 kann dann auch der Widerstand R3 bestimmt werden, da die beiden Spannungen $V_{OUT1}$ und $V_{OUT2}$ entsprechend der Figuren 2 und 3 beispielsweise mit einem Analog-Digital-Converter gemessen werden.

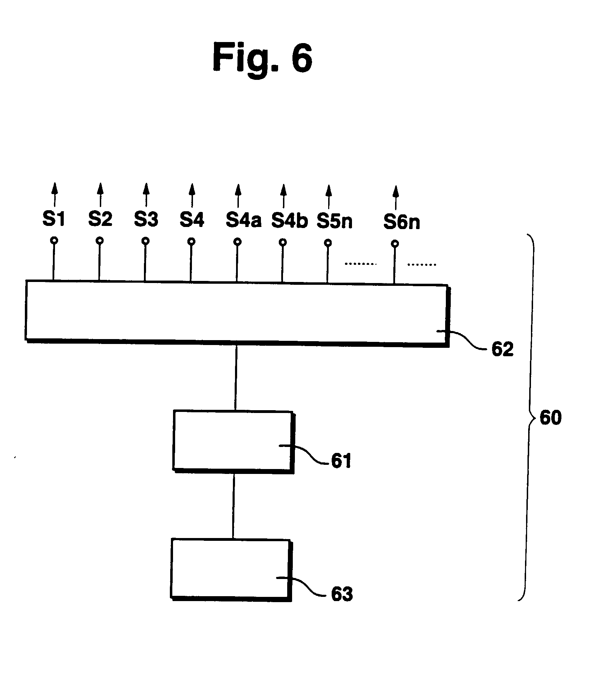

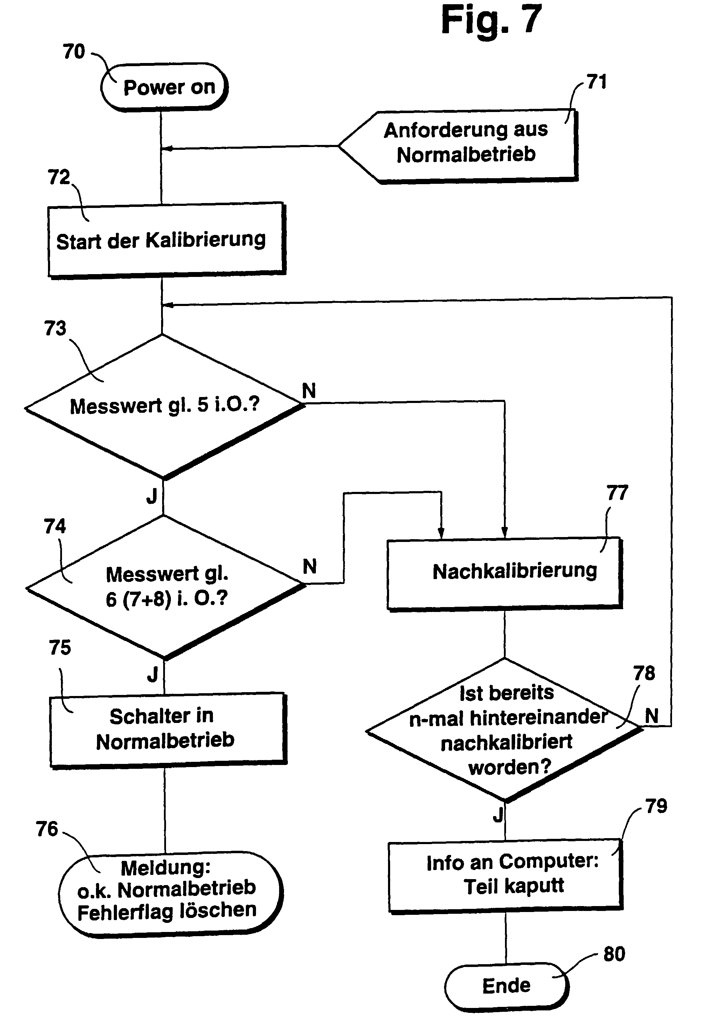

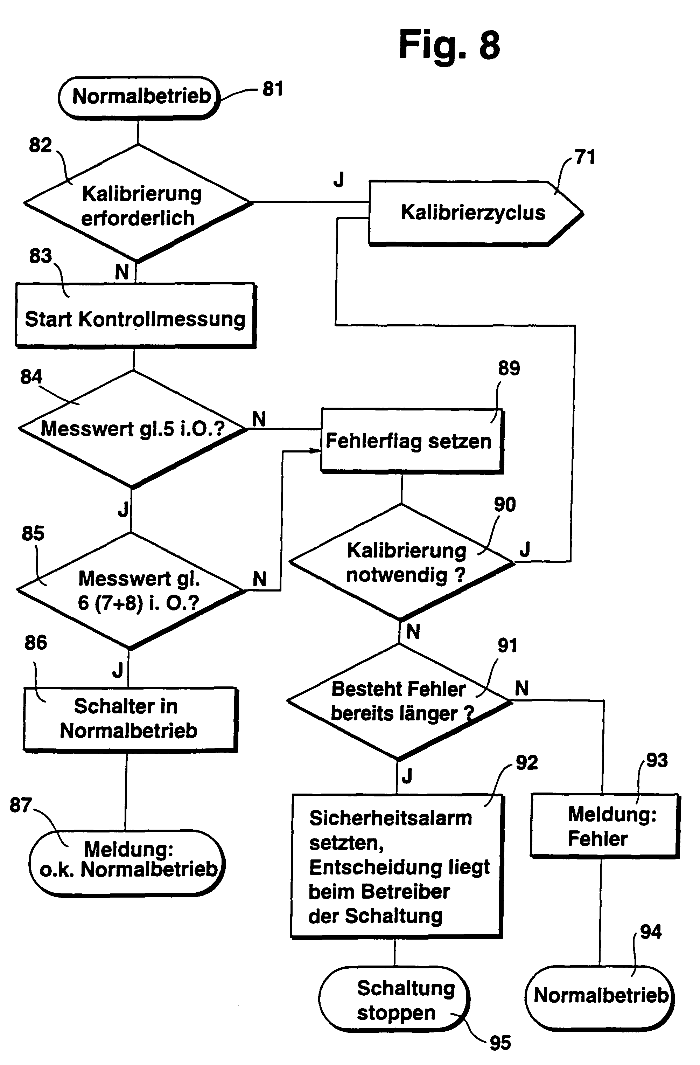

Figur 5 zeigt einen Stromlaufplan eines erfindungsgemäßen Ausführungsbeispiels, bei dem die Referenzquelle der Figur 1 mit Schaltern S1 ... S7n versehen ist. Ein erster Schalter S1 schaltet dabei den von einem Knoten 5 gebildeten Anschluß der beiden Basen der Transistoren T1, T2 wahlweise auf die Anschlüsse $V_{DD}$ oder $V_{SS}$. Ein zweiter Schalter S2 verbindet den Emitter des Transistors T2 am Knoten 4 mit dem Anschluß $V_{SS}$. Mit einem dritten Schalter S3 kann der nicht invertierende Anschluß (+) des Operationsverstärkers 1 entweder mit dem Knoten 2 oder dem Anschluß $V_{IN}$ verbunden werden. Der Knoten 2 wird dabei durch den Mittenanschluß der beiden Widerstände R1 und R2 gebildet. Ein Schalter S4 verbindet wahlweise den invertierenden Anschluß (-) des Operationsverstärkers 1 mit dem Knoten 2 oder einem Knoten 3. Der Knoten 3 wird dabei vom Emitter des Transistors T1 mit dem Widerstand R3 gebildet. Zwischen den beiden Knoten 2 und 3 sind zwei parallele Schalter S5a und S5b geschaltet. Parallel zu den Widerständen R2 und R3 sind weitere Widerstände R2n bzw. R3n in Form einer Kaskade über Schalter S6n bzw. S7n parallel schaltbar. Diese parallelen Widerstände sind als Kalibrierwiderstände während des Abgleichsvorgangs schaltbar. Die Schalter S1 ... S7n sind als Transistorschalter ausgebildet, vorzugsweise in MOS- bzw. in CMOS-Technik. Entsprechend der Figur 6 können diese Schalter über ihre Basiseingänge von einer Matrix 62 gesteuert werden, die entsprechende Ausgänge aufweist. Die Matrix wird von einem Mikroprozessor 61 gesteuert, dessen Arbeitsprogramm in einem Speicher 63 abgelegt ist und anhand der Figuren 7 und 8 für den Kalibrier- bzw. Normalbetrieb näher erläutert.

Im Normalbetrieb der Spannungsreferenz liegt gemäß Figur 5 der erste Schalter S1 auf $V_{DD}$, der zweite Schalter S2 ist geöffnet und der dritte Schalter S3 ist auf den Knoten 2 geschaltet. Entsprechend verbindet der vierte Schalter S4 den Knoten 3 mit dem invertierenden Eingang (-) des Operationsverstärkers 1. Die Schalter S6n, S7n sind je nach Kalibrierung teilweise geöffnet oder geschlossen. Die Schalter S5a und S5b sind geöffnet.

In Weitergestaltung der Erfindung ist vorgesehen, die Spannungsreferenz durch eine Referenz-Stromquelle zu ersetzen. Das Prüf- und Kalibrierverfahren läuft dann analog ab.

Anhand des Flußdiagramms der Figur 7 wird die Funktionsweise im Kalibrierbetrieb nach dem Einschalten der Betriebsspannung näher erläutert.

In Position 70 wird die Betriebsspannung eingeschaltet (Power on), so daß in Position 72 der Start der Kalibrierung erfolgt. Eine Anforderung zu einer Kalibrierung kann jedoch auch aus dem Normalbetrieb heraus gemäß Position 71 erfolgen und wird später anhand der Figur 8 näher erläutert. Nach dem Start der Kalibrierung erfolgt die Messung der

EP 0 789 866 B1

Ausgangsspannung $V_{OUT1}$, so daß in Position 73 dieser Meßwert entsprechend der Gleichung 5 auf Plausibilität geprüft werden kann. Ist dies der Fall, dann wird in Position 74 nach Gleichung 6 bzw. Gleichung 7 und 8 geprüft. Sind die Meßwerte in Ordnung, dann werden die Schalter S1, S2, S3, S4, S5a, S5b, S6n, S7n in Stellung "Normalbetrieb" gemäß der Position 75 geschaltet. In Position 76 erfolgt dann die Meldung beispielsweise an die Steuereinheit, daß der Normalbetrieb eingeschaltet und in Ordnung ist. Ein eventuell gesetztes Fehlerflag wird dann gelöscht.

War die Messung gemäß Position 73 und 74 nicht in Ordnung, dann erfolgt in Position 77 eine Nachkalibrierung, wobei entsprechend viele Schalter S6n, S67 zur Parallelschaltung weiterer Widerstände R3n bzw. R2n geschlossen werden. In Position 78 wird geprüft, ob eine vorgegebene Anzahl von Kalibrierzyklen hintereinander durchgeführt wurden. Wenn dies der Fall ist, dann erfolgt in Position 78 die Ausgabe, daß die Spannungsreferenz defekt ist. In Position 80 wird das Programm dann beendet. Ist in Position 78 beispielsweise nur einmal geprüft worden, dann beginnt der Zyklus mit der Abfrage in Position 73 erneut, um den Fehler nochmal zu überprüfen.

Figur 8 zeigt den Prüfablauf im Normalbetrieb, mit dem Start in Position 81. Wird gemäß der Position 82 eine Kalibrierung erforderlich, dann springt das Programm gemäß der Position 71 in den Kalibrierzyklus, wie er in Figur 7 erläutert wurde. Ist keine Kalibrierung erforderlich, dann startet in Position 83 die Kontrollmessung. Ist gemäß Position 84 der Meßwert der Gleichung 5 in Ordnung, dann wird in Position 86 der Meßwert der Gleichung 6 bzw. der Gleichungen 7 und 8 überprüft. Sind diese Meßwerte in Ordnung, dann werden die Schalter gemäß Position 86 wieder in "Normalbetrieb" geschaltet und in Position 87 eine entsprechende Meldung ausgegeben, daß der Normalbetrieb in Ordnung ist.

Sind die Meßwerte gemäß den Positionen 84 und 85 nicht in Ordnung, d. h. es liegt ein Fehler vor, dann wird in Position 89 ein Fehlerflag gesetzt. In Position 90 wird abgefragt, ob eine Kalibrierung notwendig ist. Ist das der Fall, dann springt das Programm auf den Kalibrierzyklus gemäß der Figur 71 zurück. Ist das nicht der Fall, dann wird in Position 91 abgefragt, ob der Fehler bereits länger besteht. Ist dies der Fall, dann wird in Position 92 ein Sicherheitsalarm gesetzt, so daß der Betreiber der Schaltungsanordnung entscheiden kann, wie er diesen Sicherheitsalarm weiter auswertet. In Position 95 kann dann beispielsweise der Schaltungsablauf gestopt werden.

Trat dagegen gemäß Position 91 ein neuer Fehler auf, dann erfolgt in Position 93 eine Meldung dieses Fehlers. In Position 94 wird dann auf "Normalbetrieb" umgeschaltet.

## Patentansprüche

1. Spannungsreferenzschaltung mit Mitteln zur Kompensation des Temperaturkoeffizienten der Ausgangsspannung der Spannungsreferenzschaltung, dadurch gekennzeichnet, daß die Spannungsreferenzschaltung eine Schaltergruppe (S1, S2, S5a, S5b, S6n, S7n) aufweist, mit der ein Selbsttest und/oder eine Eigenkalibrierung der Spannungsreferenz durchführbar ist, daß die Spannungsreferenzschaltung wenigstens einen Operationsverstärker (1) mit MOS-Eingangstransistoren aufweist, dessen Eingänge mit Schaltern (S3, S4) schaltbar sind, daß der Operationsverstärker (1) mit wenigstens einem Eingangswiderstand (R1) und einem Rückkopplungswiderstand (R2) als nicht invertierender Verstärker schaltbar ist, daß die Schaltergruppe (S1 ... S7n) als Transistorschaltergruppe vorzugsweise in der CMOS-Halbleitertechnologie ausgebildet ist und daß zwei Schalter (S5a, S5b) der Schaltergruppe parallelgeschaltet sind, die dem Rückkopplungswiderstand (R2) wenigstens einen Kalibrierwiderstand (R3) derart parallel schalten, daß die parallelen Schalter (S5a, S5b) mit einem zeitlichen Abstand geschlossen werden.

2. Spannungsreferenzschaltung nach Anspruch 1, dadurch gekennzeichnet, daß für jede der beiden Stellungen der parallelen Schalter (S5a, S5b) die Ausgangsspannung ($U_{OUT}$) der Spannungsreferenzschaltung meßbar ist und daß aus der Spannungsdifferenz der Widerstand der parallelen Schalter (S5a, S5b) bestimmbar ist.

3. Spannungsreferenzschaltung nach einem der vorhergehenden Ansprüche, dadurch gekennzeichnet, daß eine Steuerung (60) vorzugsweise mit einem Mikrocomputer (61) ausgebildet ist, die die Schaltergruppe (S1 ... S7n) nach einem vorgegebenen Programm steuert.

4. Spannungsreferenzschaltung nach einem der vorhergehenden Ansprüche, dadurch gekennzeichnet, daß die Spannungsreferenz als Bandgap-Referenzquelle ausgebildet ist.

5. Verfahren zur Prüfung und Eigenkalibrierung einer Spannungsreferenzschaltung nach einem der vorhergehenden Ansprüche, dadurch gekennzeichnet,

- daß mittels eines ersten Schalters (S1) die Basisanschlüsse eines Transistorpaares (T1, T2) der Referenzquelle auf den Ground-Anschluß ($V_{SS}$) geschaltet wird,

- daß ein zweiter Schalter (S2) den Emitter des zweiten Transistors (T2) des Transistorpaares (T1, T2) auf den Ground-Anschluß ($V_{SS}$) schaltet,

- daß ein dritter Schalter (S1) den nicht invertierenden Eingang des Operationsverstärkers (1) auf eine Eingangsspannung ($V_{IN}$) schaltet,

- daß ein vierter Schalter (S4) den invertierenden Eingang (-) des Operationsverstärkers (1) mit einem ersten Knoten (2) verbindet, der durch den Eingangswiderstand (R1) und den Rückkopplungwiderstand (R2) gebildet wird,

- daß die parallelen Schalter (S5a, S5b) mit zeitlichem Abstand geschlossen werden, wobei nach jedem Schaltvorgang die Ausgangsspannung ($U_{OUT}$) der Spannungsreferenz gemessen und ausgewertet wird und

- daß die Steuerung (60) zur Kalibrierung mittels weiterer Schalter (S6n ... S7n) Kalibrierwiderstände (R3n, R2n) dem zweiten und/oder dem dritten Widerstand (R2, R3) parallel schaltet.

6. Verfahren nach Anspruch 5, dadurch gekennzeichnet, daß die Spannungsreferenzschaltung für eine weitere Baugruppe in integrierter Schaltungstechnik verwendbar ist und daß der Prüf- und/oder der Kalibriervorgang nach dem Einschalten der Versorgungsspannung gestartet wird.

7. Verfahren nach Anspruch 5 oder 6, dadurch gekennzeichnet, daß anstelle einer Spannungsreferenzschaltung eine Stromquelle als Referenz verwendet wird.

**Claims**

1. Voltage reference circuit with means for compensating for the temperature coefficient of the output voltage of the voltage reference circuit, characterized in that the voltage reference circuit has a switch group (S1, S2, S5a, S5b, S6n, S7n), with which a self-test and/or a self-calibration of the voltage reference can be carried out, in that the voltage reference circuit has at least one operational amplifier (1) with MOS input transistors, the inputs of which amplifier can be switched by switches (S3, S4), in that the operational amplifier (1) can be connected as a non-inverting amplifier with at least one input resistor (R1) and a feedback resistor (R2), in that the switch group (S1 ... S7n) is designed as a transistor switch group preferably using CMOS semiconductor technology, and in that two switches (S5a, S5b) of the switch group are connected in parallel, which switches connect at least one calibration resistor (R3) in parallel with the feedback resistor (R2) in such a way that the parallel switches (S5a, S5b) are closed with a time interval.

2. Voltage reference circuit according to Claim 1, characterized in that the output voltage ($U_{OUT}$) of the voltage reference circuit can be measured for each of the two positions of the parallel switches (S5a, S5b), and in that the resistance of the parallel switches (S5a, S5b) can be determined from the voltage difference.

3. Voltage reference circuit according to one of the preceding claims, characterized in that a controller (60) is formed preferably with a microcomputer (61), which controller controls the switch group (S1 ... S7n) according to a predetermined program.

4. Voltage reference circuit according to one of the preceding claims, characterized in that the voltage reference is designed as a bondgap reference source.

5. Method for the testing and self-calibration of a voltage reference circuit according to one of the preceding claims, characterized

- in that the base terminals of a transistor pair (T1, T2) of the reference source are connected to the ground terminal ($V_{SS}$) by means of a first switch (S1),
- in that a second switch (S2) connects the emitter of the second transistor (T2) of the transistor pair (T1, T2) to the ground terminal ($V_{SS}$),
- in that a third switch (S1) connects the non-inverting input of the operational amplifier (1) to an input voltage ($V_{IN}$),
- in that a fourth switch (S4) connects the inverting input (-) of the operational amplifier (1) to a first node (2), which is formed by the input resistor (R1) and the feedback resistor (R2),

- in that the parallel switches (S5a, S5b) are closed with a time interval, the output voltage ($U_{OUT}$) of the voltage reference being measured and evaluated after each switching operation, and
- in that the controller (60) connects calibration resistors (R3n, R2n) in parallel with the second and/or third resistor (R2, R3) for the purpose of calibration by means of further switches (S6n ... S7n).

6. Method according to Claim 5, characterized in that the voltage reference circuit can be used for a further assembly in integrated circuit technology, and in that the testing and/or the calibration operation is started after the supply voltage has been switched on.

7. Method according to Claim 5 or 6, characterized in that instead of a voltage reference circuit, a current source is used as reference.

**Revendications**

1. Circuit de référence de tension comprenant des moyens pour compenser les coefficients de température de la tension de sortie du circuit de référence de tension,
   caractérisé en ce que

   - le circuit de référence de tension comprend un groupe d'interrupteurs (S1, S2, S5a, S5b, S6n, S7n) qui peut effectuer un autocontrôle et/ou un autocalibrage de la tension de référence,
   - le circuit de référence de tension comporte au moins un amplificateur opérationnel (1) avec des transistors d'entrée MOS, dont les entrées peuvent être commutées par des interrupteurs (S3, S4),
   - l'amplificateur opérationnel (1) peut être relié à au moins une résistance d'entrée (R1) et au moins une résistance de réaction (R2), comme amplificateur non inversé,
   - les groupes d'interrupteurs (S1...S7n) sont des groupes d'interrupteurs à transistors, de préférence en technologie de semi-conducteurs CMOS, et
   - deux interrupteurs (S5a, S5b) du groupe d'interrupteurs sont branchés en parallèle pour commuter en parallèle la résistance de réaction (R2) avec au moins une résistance de calibrage (R3) pour que les interrupteurs en parallèle (S5a, S5b) puissent être fermés avec un intervalle de temps.

2. Circuit de référence de tension selon la revendication 1,
   caractérisé en ce que
   pour chacune des deux positions des interrupteurs parallèles (S5a, S5b), on peut mesurer la tension de sortie ($U_{OUT}$) du circuit de référence de tension et, à partir de cette différence de tension, on détermine la résistance des interrupteurs en parallèle (S5a, S5b).

3. Circuit de référence de tension selon l'une des revendications précédentes,
   caractérisé par
   une commande (60) réalisée de préférence avec un micro-ordinateur (61) qui commande le groupe d'interrupteurs (S1...S7n) selon un programme prédéterminé.

4. Circuit de référence de tension selon l'une des revendications précédentes,
   caractérisé en ce que
   la référence de tension est une source de référence à intervalle de bande.

5. Procédé de contrôle et de calibrage propre d'un circuit de référence de tension selon l'une quelconque des revendications précédentes,
   caractérisé en ce que

   - un premier interrupteur (S1) relie la borne de base d'une paire de transistors (T1, T2) de la source de référence, à la borne de base ($V_{SS}$),
   - un second interrupteur (S2) commute l'émetteur du second transistor (T2) de la paire de transistors (T1, T2), sur la borne de base ($V_{SS}$),
   - un troisième interrupteur (S1) commute l'entrée inversée de l'amplificateur opérationnel (1) sur une tension d'entrée ($V_{IN}$),
   - un quatrième interrupteur (S4) relie l'entrée inversée (-) de l'amplificateur opérationnel (1) à un premier noeud (2) formé par la jonction de la résistance d'entrée (R1) et de la résistance de réaction (R2),

- les interrupteurs en parallèle (S5a, S5b) sont fermés avec un intervalle de temps et, suivant l'opération de commutation, on mesure et on exploite la tension de sortie ($U_{OUT}$) de la référence de tension, et

- la commande (60) de calibrage se fait par la commutation d'autres interrupteurs (S6n...S7n) qui branchent des résistances de calibrage (R3n, R2n) en parallèle sur la seconde et/ou la troisième résistance (R2, R3).

6. Procédé selon la revendication 5,
   caractérisé en ce que
   le circuit de référence de tension est applicable à un autre ensemble en technique intégrée, et l'opération de contrôle et/ou calibrage est démarrée après le branchement de la tension d'alimentation.

7. Procédé selon les revendications 5 et 6,
   caractérisé en ce qu'
   à la place d'un circuit de tension de référence, on utilise une source d'intensité comme référence.

# Fig. 1

# Fig. 2

# Fig. 3

# Fig. 4

# Fig. 5

# Fig. 6

S1  S2  S3  S4  S4a S4b S5n    S6n

62

60

61

63

# Fig. 7

70 — ( Power on )

71 — Anforderung aus Normalbetrieb

72 — Start der Kalibrierung

73 — Messwert gl. 5 i.O.? —N→

J

74 — Messwert gl. 6 (7+8) i. O.? —N→

J

77 — Nachkalibrierung

75 — Schalter in Normalbetrieb

76 — Meldung: o.k. Normalbetrieb Fehlerflag löschen

78 — Ist bereits n-mal hintereinander nachkalibriert worden? —N→

J

79 — Info an Computer: Teil kaputt

80 — ( Ende )

# Fig. 8

Normalbetrieb — 81

82 — Kalibrierung erforderlich

J → Kalibrierzyclus — 71

N

83 — Start Kontrollmessung

84 — Messwert gl.5 i.O.?

N → Fehlerflag setzen — 89

J

85 — Messwert gl. 6 (7+8) i. O.?

N → Kalibrierung notwendig ? — 90

J → (to Kalibrierzyclus)

86 — Schalter in Normalbetrieb

N

87 — Meldung: o.k. Normalbetrieb

91 — Besteht Fehler bereits länger?

N → Meldung: Fehler — 93

J

92 — Sicherheitsalarm setzten, Entscheidung liegt beim Betreiber der Schaltung

Schaltung stoppen — 95

Normalbetrieb — 94